# EUROPEAN PATENT APPLICATION

(11) **EP 1 251 635 A1**
(43) Date of publication of application: **23.10.2002**
(21) Application number: 01201438.7
(22) Date of filing: 20.04.2001
(51) Int. Cl.: H03F 3/45

(54) **Tunable resonance amplifier**

(71) Applicant: Semiconductor Ideas to The Market (ItoM) BV, 4839 AH Breda (NL)
(72) Inventor: Kasperkovitz, Wolfdietrich Georg, 5581 HA Waalre (NL)
(74) Representative: Van Straaten, Joop

(57) **Abstract**

Tuneable resonance amplifier comprising a cascade circuit of first and second sections each having a controllable gain and comprising first and second transconductance amplifiers, respectively, outputs of which are coupled via first and second capacitors to inputs of the second and first gain controlled amplifiers, said first and second capacitors being coupled in parallel to first and second load resistors to form therewith first and second parallel RC filters, respectively, a tuning control current being supplied to control inputs of the first and second transconductance amplifiers, said first transconductance amplifier having a differential pair of first and second output terminals and said second transconductance amplifier having a differential pair of third and fourth output terminals. To provide a highly selective tuneable resonance amplifier operable in a wide tuning range at a low supply voltage, said first load resistor is coupled between the first and second output terminals, and said second load resistor being coupled between the third and fourth output terminals respectively, said first to fourth output terminals being respectively coupled to first to fourth DC current paths shunting at least a substantial part of said tuning control current to a supply voltage.

## Description

The invention relates to a tuneable resonance amplifier comprising a cascade circuit of first and second sections each having a controllable gain and comprising first and second transconductance amplifiers, respectively, outputs of which are coupled via first and second capacitors to inputs of the second and first gain controlled amplifiers, said first and second capacitors being coupled in parallel to first and second load resistors to form therewith first and second parallel RC filters, respectively, a tuning control current being supplied to control inputs of the first and second transconductance amplifiers, said first transconductance amplifier having a differential pair of first and second output terminals and said second transconductance amplifier having a differential pair of third and fourth output terminals. Such tuneable resonance amplifier is known from US patent number 5,220,686, which is herein incorporated by reference. The known tuneable resonance amplifier is capable of amplifying within a certain tuning range a pair of phase quadrature sinusoidal input signals into a pair of phase quadrature output signals and/or converting the same into a single phase output signal or, amplifying a single phase input signal into a single phase output signal and/or converting the same into a pair of phase quadrature output signals.

The tuning range of the known tuneable resonance amplifier is limited by conditions of high filter quality factor Q or selectivity and low supply voltage. As known, the resistance value of the load resistors has to be large for a high filter selectivity or narrow bandwidth. On the other hand, the tuning control current is highest at the highest tuning frequency and therewith also the voltage drop across the load resistor. This jeopardizes proper functioning of the first and second transconductance amplifiers, in particular so if the resistance value of the load resistor is increased e.g. to increase selectivity, while keeping the supply voltage down.

It is an object of the invention to provide a highly selective tuneable resonance amplifier operable in a wide tuning range at a low supply voltage.

Now therefore, according to one of its aspects the invention is characterized by said first load resistor being coupled between the first and second output terminals, and said second load resistor being coupled between the third and fourth output terminals respectively, said first to fourth output terminals being respectively coupled to first to fourth DC current paths shunting at least a substantial part of said tuning control current to a supply voltage.

The invention is based on the recognition that the first and second load resistors resistances provide a DC function in the biasing of the resonance amplifier and an AC function in the signal selection process together with the first and second capacitors. By an appropriate separation of these functions, the above conflict in requirements with respect to the resistance value of the load resistors, arising when both conditions of high selectivity and low supply voltage are combined, is prevented from occurring.

The above measure according to the invention results in the first to fourth DC current paths carrying at least the greater part of the tuning and gain control currents of the resonance amplifier, whereas the load resistors are mainly effective in the AC signal processing of the resonance amplifier and hardly not in the biasing thereof. The resistance R of the load resistors can therefore be chosen at relatively very high values causing the selectivity to increase dramatically, without requiring to increase the supply voltage.

Preferably, said first to fourth DC current paths comprising first to fourth controlled DC current sources, respectively, said first and second controlled DC current sources and said third and fourth controlled DC current sources providing DC currents corresponding to substantially half the summation of said tuning and gain control currents of each section.

This measure allows accurate control in shunting of the tuning control current to the bias voltage.

A first preferred embodiment, in which feed back control is applied to secure such accurate shunting is characterized in that the resistance of said first and second parallel RC filters is being provided by a serial arrangement of a pair of mutually substantially equal resistors, the DC voltage at the common node between said first and second resistors van de first en second RC filters being negatively fed back to control inputs of the respective first to fourth controlled DC current sources. By applying this measure, the DC voltage at the common node is used to derive a control signal for the controlled DC current sources.

Preferably, said common node is coupled to an input of a control signal generating device, comprising a comparator for comparing said DC signal voltage with a set level to provide a current control signal to the respective first to fourth controlled DC current sources for a negative feedback of signal differences between said DC signal voltage and said set level.

A second preferred embodiment, in which feed forward control is applied to secure said accurate shunting is characterized by gain and tuning current mirror means, inputs thereof being supplied with said gain and tuning control currents, respectively, outputs thereof coupled through summation means to control inputs of said first to fourth controlled DC current sources, respectively.

Preferably, the first and second load resistors are provided by a serial arrangement of a pair of mutually substantially equal resistances, the common node between the pair of resistances of said first and second load resistors being coupled to a reference voltage.

The invention allows to introduce a bandwidth control feature, while preventing the control current for this feature to jeopardize proper functioning of the tuneable resonance amplifier and/or requiring to increase the supply voltage.

Therefore a preferred embodiment of invention is being characterized by third and fourth transconductance amplifiers, which are positively fed back from the output to the input and coupled to said first and second load resistors a bandwidth control current being supplied to said third and fourth transconductance amplifiers to vary the resistance value of the first and second load resistors, respectively, said first to fourth DC current paths shunting at least a substantial part of said tuning control current and/or said bandwidth control current to the supply voltage.

The invention furthermore allows to introduce a gain control feature and also here, the control current for this feature is prevented from jeopardizing proper functioning of the tuneable resonance amplifier and/or from reducing the bias voltage across the various transconductance amplifiers.

Therefore a preferred embodiment of invention is being characterized by fifth and sixth transconductance amplifiers coupled between a pair of phase quadrature input terminals and a pair of phase quadrature output terminals of the tuneable resonance amplifier, having the outputs of the first and second transconductance amplifiers in common, a gain control current being supplied to said fifth and sixth transconductance amplifiers to vary the gain of the tuneable resonance amplifier, said first to fourth DC current paths.

These and further aspects and advantages of the invention will be discussed more in detail hereinafter with reference to the disclosure of preferred embodiments, and in particular with reference to the appended Figures in which like reference numerals refer to like elements wherein:
Figure 1 is a block diagram of a resonance amplifier according to the invention;
Figure 2 is a schematic diagram of a first preferred embodiment of a resonance amplifier according to the invention having a DC feedback loop;
Figure 3 is a schematic diagram of a second preferred embodiment of a resonance amplifier according to the invention having a DC feed forward loop.

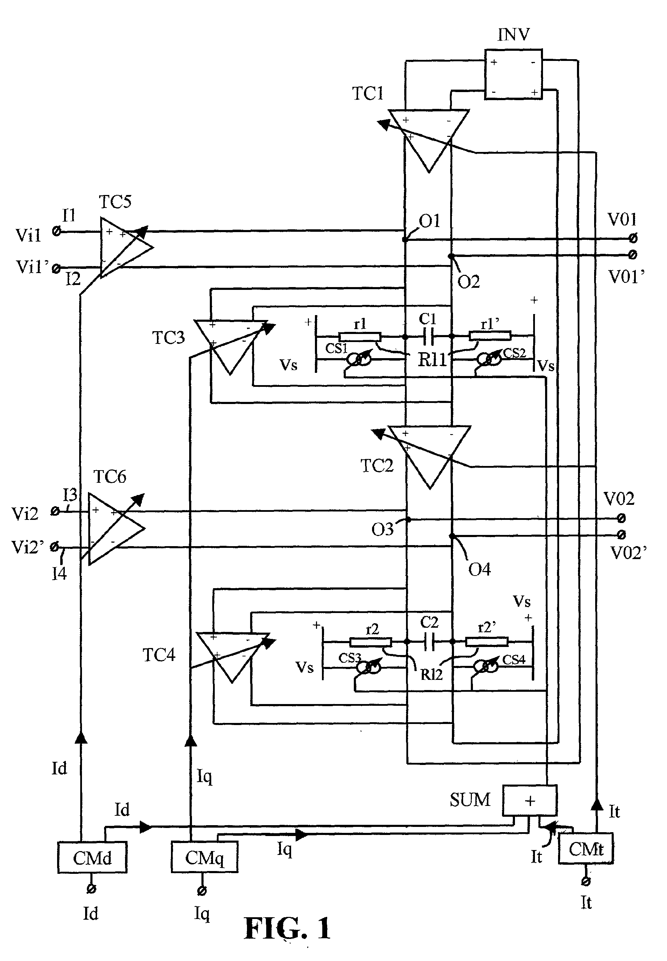

Figure 1 is a block diagram of a tuneable resonance amplifier according to the invention comprising a cascade circuit of first and second sections TC1, TC3, TC5, R11C1 and TC2, TC4, TC6, R12C2, each having a controllable gain and comprising first and second transconductance amplifiers TC1 and TC2, respectively, outputs 01, 02 and 03, 04 of which are coupled to third and fourth transconductance amplifiers TC3 and TC4, which are positively fed back from the output to the input, and via first and second capacitors C1 and C2 and an inverter INV to inputs of the second and first gain controlled amplifiers TC2 and TC1. The first and second capacitors C1 and C2 are coupled in parallel to first and second load resistors R11 and R12, respectively, to form therewith first and second parallel filters R11C1 and R12C2, respectively. Said first and second sections TC1, TC3, TC5, R11C1 and TC2, TC4, TC6, R12C2 also comprise fifth and sixth transconductance amplifiers TC5 and TC6, respectively, inputs I1, I2 and I3, I4 thereof constituting a pair of differential phase quadrature inputs of the resonance amplifier and outputs thereof being coupled in common to the outputs 01, 02 and 03, 04 of the first and second transconductance amplifiers TC1 and TC2, respectively, constituting a pair of differential phase quadrature outputs of the resonance amplifier. This means that said first, third and fifth transconductance amplifiers TC1, TC3 and TC5 of the first section TC1, TC3, TC5, R11C1 have a differential pair of first and second output terminals 01, 02 in common, said second, fourth and sixth transconductance amplifiers TC2, TC4, TC6 of the second section TC2, TC4, TC6, R12C2 having a differential pair of third and fourth output terminals 03, 04 in common. The first capacitor C1 is coupled between the first and second output terminals O1 and 02 and the second capacitor C2 is coupled between the third and fourth output terminals 03 and 04.

A tuning control current It is supplied to control inputs of the first and second transconductance amplifiers TC1 and TC2. A bandwidth control current Iq is supplied to control inputs of the third and fourth transconductance amplifiers TC3 and TC4. A gain control current Id is supplied to control inputs of the fifth and sixth transconductance amplifiers TC5 and TC6.

First and second load resistors R11 and R12 are constituted by a serial arrangement of a pair of mutually substantially equal resistances r1, r1' and r2, r2' respectively, each providing half the resistance value of each of said resistors R11 and R12. Said resistances r1, r1' are AC coupled in parallel to the first capacitor C1 and DC coupled to a supply voltage Vs. Likewise, said resistances r2, r2' are AC coupled in parallel to the second capacitor C2 and DC coupled to said supply voltage Vs. This causes the DC voltage at the first and second output terminals O1 and 02 and the DC voltage at the third and fourth output terminals 03 and 04 to vary with the tuning, bandwidth and/or gain control currents It, Iq and/or Id. The higher the resonance frequency the larger the voltage drop across these resistances r1, r1' and r2, r2' and the lower the voltage left for biasing the various transconductance amplifiers. The tuneable resonance amplifier described sofar is on itself known. For further details, reference is made to the above cited US patent number 5,220,686.

According to the invention, however, the resistances r1, r1' constituting said first load resistors R11 are substantially freed from DC currents passing through. This is obtained by the use of first to fourth DC current paths shunting at least a substantial part of said tuning and gain control currents It and Iq to said supply voltage. These DC current paths comprise first to fourth controlled DC current sources CS1 to CS4, respectively, said first and second controlled DC current sources CS1 and CS2 and said third and fourth controlled DC current sources CS3 and CS4 providing DC currents corresponding to substantially half the summation of said tuning and gain control currents It and Iq of each section TC1, TC3, R11C1 and TC2, TC4, R12C2.

The current control signal needed for the controlled DC current sources CS1 to CS4 to provide said DC currents is obtained by the summation of mirrored copies of the tuning, bandwidth and gain control currents It, Iq and Id. For this purpose, the tuning control current It is being supplied to an input of a tuning control current mirror CMt, the AGC signal current Iq is being supplied to an input of a bandwidth control current mirror CMq and the gain control current Id is being supplied to an input of a gain control current mirror CMd. The tuning control current mirror CMt provides a pair of mutually identical tuning control currents It, the one being supplied to control inputs of the first and second transconductance amplifiers TC1 and TC2, the other being supplied to a first input of a summation device SUM. The gain control current mirror CMq provides a pair of mutually identical bandwidth control currents Iq, the one being supplied to control inputs of the third and fourth transconductance amplifiers TC3 and TC4, the other being supplied to a second input of the summation device SUM. The gain control current mirror CMd provides a pair of mutually identical gain control currents Id, the one being supplied to control inputs of the fifth and sixth transconductance amplifiers TC5 and TC6, the other being supplied to a third input of the summation device SUM. An output of the summation device SUM is coupled in common to control inputs of the first to fourth controlled DC current sources CS1-CS4 to vary the DC currents provided by these DC current sources to correspond to substantially half the summation of said tuning, bandwidth and gain control currents It, Iq and Id of each section TC1, TC3, TC5, R11C1 and TC2, TC4, TC6, R12C2. This substantially reduces the DC currents through the resistances r1, r1' and r2, r2', therewith allowing to dramatically increase these resistances and therewith the gain, selectivity and the tuning range of the resonance amplifier, while fixing the DC bias voltage at the outputs 01, 02 and 03, 04 at an optimized working point for the various transconductance amplifiers..

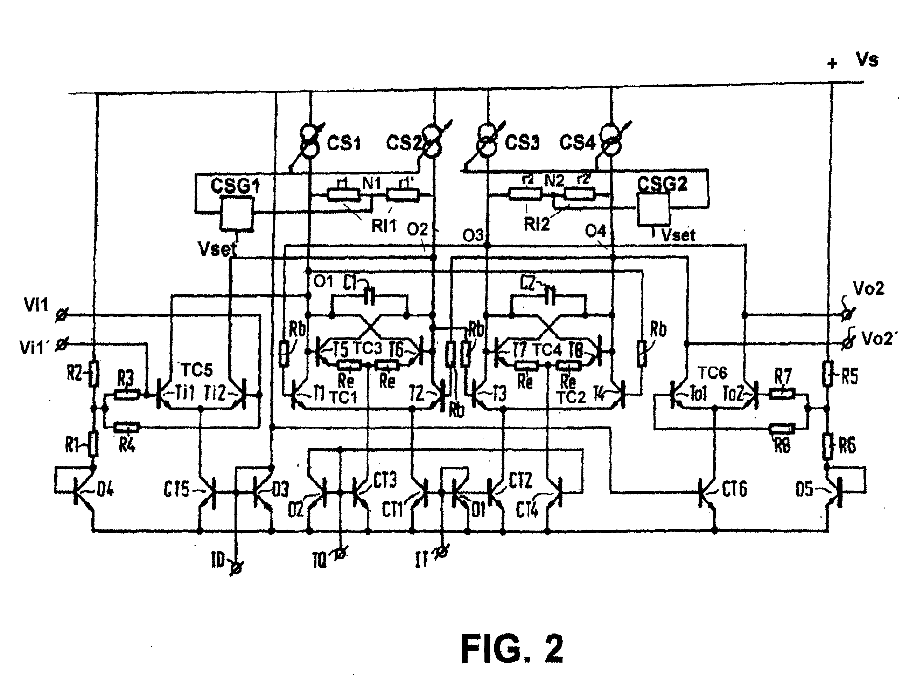

Figure 2 is a schematic diagram of a first preferred embodiment of the invention having a DC feedback loop providing an improvement of the tuneable resonance amplifier as shown in Figure 5 of the above cited US patent. For an understanding of the functioning of the part of the tuneable resonance amplifier according to the invention corresponding to said known the tuneable resonance amplifier, reference is made to this US patent.

The tuneable resonance amplifier resonance amplifier according to the invention deviates from the known resonance amplifier in that the first load resistors R11 is constituted by a serial arrangement of the abovementioned mutually substantially equal resistances r1, r1' being coupled between the first and second output terminals 01 and 02 of the first section TC1, TC3, TC5, R11C1 and in that the second load resistor R12 is constituted by a serial arrangement of the abovementioned mutually substantially equal resistances r2 and r2' being coupled between the third and fourth output terminals 03 and 04 of the second section TC2, TC4, TC6, R12C2. The first to sixth transconductance amplifiers TC1-TC6 herein are being provided respectively by transistorpairs: T1 and T2; T3 and T4; T5 and T6; T7 and T8; Ti1 and Ti2; To1 and To2, whereas the above first to second output terminals 01-04 are being constituted by the collectors of T1-T4, respectively. The abovementioned first to fourth DC current paths are provided between the first to fourth output terminals 01 to 04, respectively, shunting said tuning, bandwidth and gain control currents to said supply voltage Vs, preferably wholly, but at least a substantial part thereof. For this purpose, these DC current paths comprise first to fourth controlled DC current sources CS1 to CS4, respectively, said first and second controlled DC current sources CS1 and CS2 and said third and fourth controlled DC current sources CS3 and CS4 providing DC currents corresponding to substantially half the summation of said tuning, bandwidth and gain control currents It, Iq and Id of each section TC1, TC3, R11C1 and TC2, TC4, R12C2.

The DC voltage level variation at the common node between the resistances r1 and r1', hereinafter being referred to as node N1, represents the common mode variation at the first and second outputs 01 and 02, reflecting the variation in tuning, bandwidth and gain control currents passing through said first and second controlled DC current sources CS1 and CS2. Likewise, the DC voltage level variation at the common node between the resistances r2 and r2', hereinafter being referred to as node N2, represents the common mode variation at the third and fourth outputs 03 and 04, reflecting the variation in tuning, bandwidth and gain control currents passing through said third and fourth controlled DC current sources CS3 and CS4.

The DC voltage level at the respective nodes N1 and N2 are being used to measure the deviation thereof from a set voltage Vset in respective first and second control signal generating devices CSG1 and CSG2. These voltage level deviations are negatively fed back to the control inputs of the first and second controlled DC current sources CS1 and CS2, respectively, to the control inputs of the third and fourth controlled DC current sources CS3 and CS4. This results in a suppression of said level deviations, i.e. in an accurate control of the first to fourth controlled DC current sources CS1 to CS4. The DC currents passing resistances R11, R11', r2 and r2' only need to be large enough for a proper operation of said feed back loop, which is in the order of magnitude of 1% of the DC currents passing these resistances in the known resonance amplifier. This allows to substantially extend the gain, selectivity and tuning range of the resonance amplifier without the need for increasing the supply voltage Vs.

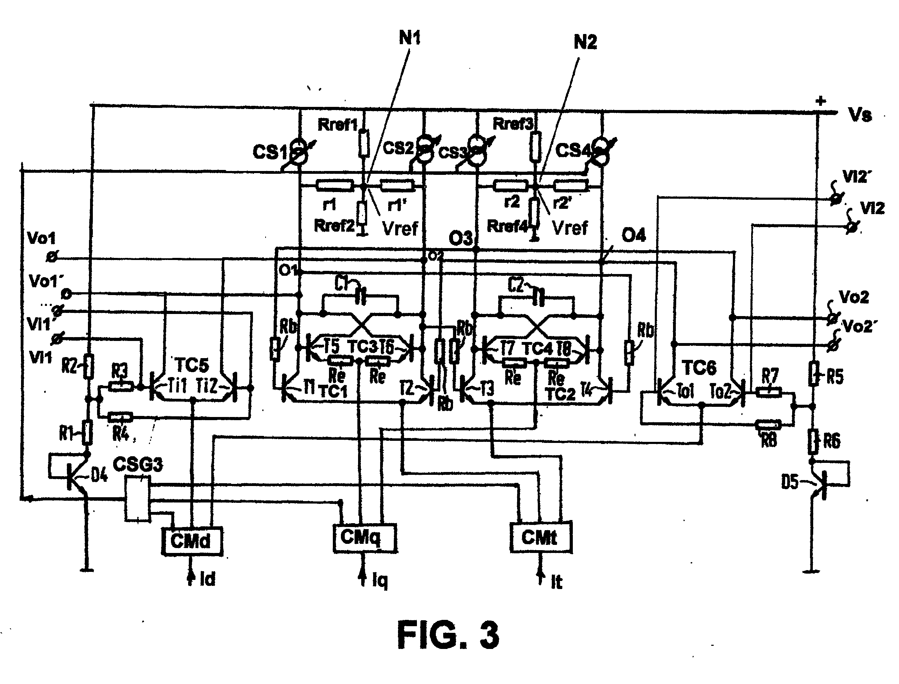

Figure 3 is a schematic diagram of a second preferred embodiment of the invention, in which elements corresponding to those of Figure 2 are being provided with the same reference numerals. This second preferred embodiment of the invention comprises a DC feedforward loop providing an improvement with regard to the resonance amplifier as shown in Figure 5 of the above cited US patent. For the sake of clarity the current mirrors of the known resonance amplifier constituted by the elements D1, CT1, CT2; D2, CT3, CT4; D3, CT5, CT6 are being included in basically mutually corresponding current mirrors CMt, CMq and CMd, respectively. The current mirrors CMt, CMq and CMd differ from the current mirrors D1, CT1, CT2; D2, CT3, CT4; D3, CT5, CT6 of the known resonance amplifier merely, in that they provide three, instead of two output currents. Where two of these three output currents are used in conformity with the two tuning control currents It, the two bandwidth or selectivity control currents Iq and the two gain control currents Id of the current mirrors D1, CT1, CT2; D2, CT3, CT4; D3, CT5, CT6, respectively, of the known resonance amplifier, the third output currents of the current mirrors CMt, CMq and CMd - being identical to the tuning control current It, the bandwidth or selectivity control current Iq and the gain control current Id, respectively - are summarized in a control signal generating device CSG3. The summation of these tuning, bandwidth and gain control currents It, Iq and Id is supplied to control inputs of the first to fourth controlled DC current sources CS1-CS4, which are controlled to each provide a DC current corresponding to substantially half the summation of said tuning, bandwidth and gain control currents It, Iq and Id of each section TC1, TC3, TC5 and TC2, TC4, TC6.

For a proper operation of so obtained feed forward loop, the voltage at the common nodes N1 and N2 have to be fixed at a reference level Vref being provided e.g. at the output tap of first and second voltage dividers Rref1, Rref2 and Rref3, Rref4, respectively.

This results in an accurate shunting of the DC control currents It, Iq and Id from the outputs 01-04 of both first and second sections TC1, TC3, TC5 and TC2, TC4, TC6 to the supply voltage Vs. Only very small DC current differences due to mismatch between the control currents It, Iq and Id as summarized in the control signal generating device CSG3 on the one hand, and the control signals It, Iq and Id supplied by the transconductance amplifiers TC1, TC3, TC5 to the common outputs 01, 02 of the first section, respectively, the control signals It, Iq and Id supplied by the transconductance amplifiers TC2, TC4, TC6 to the common outputs 03, 04 of the second section, pass through resistances R11, R11', r2 and r2', which may be in the order of magnitude of 1% of the DC currents passing these resistances in the known resonance amplifier. This allows to substantially increase the resistance value of the resistors RL1 and R2, constituted by these resistances R11, R11', r2 and r2', and to therewith extend the gain, selectivity and tuning range of the resonance amplifier without the need for increasing the supply voltage Vs.

While the invention has been particularly shown and described with reference to the preferred embodiments thereof, it will be understood by those skilled in the art that various changes in form and details may be made without departing from the spirit and scope of the invention.

For instance, resonance amplifiers not using the third and fourth transconductance amplifiers TC3 and TC4 and/or the fifth and sixth transconductance amplifiers TC5 and TC6, e.g. when there is no necessity to vary the bandwidth and/or the gain of the resonance amplifier, benefit to the same extent from the invention as the embodiments shown. It will be understood that the currents. It will be understood that the currents supplied by the first to fourth current sources CS1-CS4 should be adapted accordingly.

Furthermore, because of the many parameters that can easily be varied, the resonance amplifier according to the invention is in particular suitable for use as building block in integrated system concepts. Where the set voltage Vset and the reference voltage Vref in respectively the first and second preferred embodiment of the invention, may be used to electronically align the resonance amplifier in supply voltage, DC common mode and/or working point to peripheral input and output signal processing circuits, the control currents It, Id and Iq allow electronic alignment in resonance frequency, gain and bandwidth. In addition thereto, by a planary integrated implemention of the load resistors R11, R12 and C1, C2, respectively, as digitally controlled switched ladderstructures, further parameters are provided allowing easy alignment in impedance level and therewith dynamic range.

## Claims

1. Tuneable resonance amplifier comprising a cascade circuit of first and second sections each having a controllable gain and comprising first and second transconductance amplifiers, respectively, outputs of which are coupled via first and second capacitors to inputs of the second and first gain controlled amplifiers, said first and second capacitors being coupled in parallel to first and second load resistors to form therewith first and second parallel RC filters, respectively, a tuning control current being supplied to control inputs of the first and second transconductance amplifiers, said first transconductance amplifier having a differential pair of first and second output terminals and said second transconductance amplifier having a differential pair of third and fourth output terminals **characterized by** said first load resistor being coupled between the first and second output terminals, and said second load resistor being coupled between the third and fourth output terminals respectively, said first to fourth output terminals being respectively coupled to first to fourth DC current paths shunting at least a substantial part of said tuning control current to a supply voltage.

2. Tuneable resonance amplifier according to claim 1, **characterized by** third and fourth transconductance amplifiers, which are positively fed back from the output to the input and coupled to said first and second load resistors a bandwidth control current being supplied to said third and fourth transconductance amplifiers to vary the resistance value across the first and second load resistors, respectively, said first to fourth DC current paths shunting at least a substantial part of said tuning control current and/or said bandwidth control current to the supply voltage.

3. Tuneable resonance amplifier according to claim 1 or 2, **characterized by** fifth and sixth transconductance amplifiers coupled between a pair of phase quadrature input terminals and a pair of phase quadrature output terminals of the tuneable resonance amplifier, having the outputs of the first and second transconductance amplifiers in common, a gain control current being supplied to said fifth and sixth transconductance amplifiers to vary the gain of the tuneable resonance amplifier, said first to fourth DC current paths shunting at least a substantial part of said tuning control current, said bandwidth control current and/or said gain control voltage to the supply voltage.

4. Tuneable resonance amplifier according to one of claims 1 to 3, **characterized by** said first to fourth DC current paths comprising first to fourth controlled DC current sources, respectively, said first and second controlled DC current sources and said third and fourth controlled DC current sources providing DC currents corresponding to substantially half the summation of said tuning control current, said bandwidth control current and/or said gain control voltage.

5. Tuneable resonance amplifier according to one of claims 1 to 4, **characterized in that** the resistance of said first and second parallel RC filters is being provided by a serial arrangement of a pair of mutually substantially equal resistors, the DC voltage at the common node between said first and second resistors van de first en second RC filters being negatively fed back to control inputs of the respective first to fourth controlled DC current sources.

6. Tuneable resonance amplifier according to claim 5, **characterized in that** said common node is coupled to an input of a control signal generating device, comprising a comparator for comparing said DC signal voltage with a set level to provide a current control signal to the respective first to fourth controlled DC current sources for a negative feedback of signal differences between said DC signal voltage and said set level.

7. Tuneable resonance amplifier according to one of claims 1 to 4, **characterized by** current mirror means, inputs thereof being supplied with said tuning, bandwidth and/or gain control currents, respectively, outputs thereof coupled to control inputs of said first to fourth controlled DC current sources, respectively.

8. Tuneable resonance amplifier according to claim 7, **characterized in that** the first and second load resistors are provided by a serial arrangement of a pair of mutually substantially equal resistances, the common node between the pair of resistances of said first and second load resistors being coupled to a reference voltage.
